# EUROPEAN PATENT APPLICATION

(11) **EP 3 483 925 A1**
(43) Date of publication of application: **15.05.2019**
(21) Application number: 17827857.8
(22) Date of filing: 04.07.2017
(51) Int. Cl.: H01L 21/683, H01L 21/02, H01L 21/67, H01L 21/68

(54) **CHUCK PLATE FOR SEMICONDUCTOR POST-PROCESSING, CHUCK STRUCTURE HAVING SAME CHUCK PLATE AND CHIP SEPARATING APPARATUS HAVING SAME CHUCK STRUCTURE**

(30) Priority: 11.07.2016 KR 20160087260
(71) Applicant: MICO Ltd., Anseong-si, Gyeonggi-do 17567 (KR)
(72) Inventor: JEON, Young Kon, Andong-si Gyeongsangbuk-do 36679 (KR); NAM, Sung Yong, Osan-si Gyeonggi-do 18146 (KR); KIM, Min Ki, Anseong-si Gyeonggi-do 17552 (KR); JUNG, In Young, Seongnam-si Gyeonggi-do 13228 (KR)
(74) Representative: Casalonga
(86) International application number: PCT/KR2017/007090
(87) International publication number: WO 2018/012783

(57) **Abstract**

A chuck structure includes a heating plate having a heating element that generates a heat by an external power source, and a first vacuum line extending to an upper surface thereof for providing a vacuum force, and a chuck plate being placed on the heating plate to support a wafer including a plurality of chips, attached to a dicing tape on an upper surface thereof, the chuck plate being configured to transfer heat generated in the heating plate to the wafer so that the chips are separated from the dicing tape, and having a second vacuum line being communicated with the first vacuum line for adsorbing the dicing tape. Thus, the chips can be separated from the dicing tape with damage.

## Description

### [Technical Field]

The present disclosure relates to a chuck plate for a semiconductor post processing step, a chuck structure having the chuck plate, and a chip separating apparatus having the chuck structure, and more particularly to a chuck plate for supporting a wafer diced into a plurality of chips with a dicing tape, a chuck structure having the chuck plate, and a chip separating apparatus having the chuck structure.

### [Background Art]

Generally, a semiconductor manufacturing process can be classified into a preprocessing step and a post processing step.

The preprocessing step may include a deposition process, a photoresist coating process, an exposure process, a development process, an etching process, a cleaning process, an inspection process, etc.

The post processing step corresponds to a process of dicing a wafer on which a plurality of chips is formed through the preprocessing step to make each of the chips into one independent semiconductor device. The post processing step may include a dicing process, a packaging process, an assembly process, a cleaning process, etc.

In order to carry out the packaging process in the post processing step, the chips are transported in a state in which a chuck holds the wafer attached to a dicing tape, to be individualized by a plurality of chips. An eject pin is provided at a lower portion of the chuck to press a back surface of the dicing tape and to separate each of the chips from the dicing tape.

However, as the chips are miniaturized and thinned, the chips may be damaged by a force that the eject pin presses through the dicing tape.

### [Disclosure]

### [Technical Problem]

The present disclosure provides a chuck plate for a semiconductor post processing step capable of separating chips from a dicing tape without damage.

The present disclosure also provides a chuck structure having the chuck plate for the semiconductor post processing step

The present disclosure also provides a chip separating apparatus.

### [Technical Solution]

In accordance with an exemplary embodiment, a chuck plate for a semiconductor post processing step, includes a plurality of vacuum holes penetrating therethrough to adsorb a dicing tape using a vacuum force, wherein the chuck plate is placed on a heating plate to support a wafer including a plurality of chips and being attached to the dicing tape, and heat generated in the heating plate transfers to the wafer for thermally separating the chips from the dicing tape.

In an example embodiment, the chuck plate may further include a vacuum groove pattern being communicated with the vacuum holes formed on a lower surface of the chuck plate.

In an example embodiment, the chuck plate may have a lower surface having a flatness of about 10 *µ*m or less.

In accordance with an exemplary embodiment, a chuck structure includes a heating plate having a heating element that generates a heat by an external power source, and a first vacuum line extending to an upper surface thereof for providing a vacuum force, and a chuck plate being placed on the heating plate to support a wafer including a plurality of chips, attached to a dicing tape on an upper surface thereof, the chuck plate being configured to transfer heat generated in the heating plate to the wafer so that the chips are separated from the dicing tape, and having a second vacuum line being communicated with the first vacuum line for adsorbing the dicing tape.

In an example embodiment, the second vacuum line may include a vacuum groove pattern communicated to the first vacuum line, the vacuum groove pattern being formed on a lower surface of the chuck plate to define a vacuum space together with the lower surface of the chuck plate and the upper surface of the heating plate, and a plurality of vacuum holes extending through the chuck plate and from the lower surface to the upper surface of the chuck plate.

In an example embodiment, the first vacuum line may include a vacuum groove pattern communicated to the second vacuum line, the vacuum groove pattern being formed on the upper surface of the heating plate to define a vacuum space together with an lower surface of the chuck plate and the upper surface of the heating plate, and a plurality of vacuum holes extending through the heating plate and from the lower surface to the upper surface of the heating plate.

In an example embodiment, the chuck structure may further include an alignment pin disposed on one of the upper surface of the heating plate and a lower surface of the chuck plate, and a receiving groove formed on the other of the upper surface of the heating plate and the lower surface of the chuck plate for receiving the alignment pin.

In an example embodiment, the heating plate and the chuck plate may be made of aluminum nitride (AlN) to uniformly transmit heat generated from the heating plate such that the chuck plate has a uniform temperature distribution internally.

In an example embodiment, the chuck structure may further include a guide ring which hangs on a groove formed along an edge portion of the upper surface of the heating plate to guide a periphery of the heating plate, and a clamp being fixed to the guide ring while covering an edge portion of the upper surface of the chuck plate to make the chuck plate in contact with the heating plate for fixing the chuck plate to the heating plate.

In an example embodiment, the clamp may hang on a groove formed along a peripheral portion of the chuck plate such that an upper surface of the clamp is coplanar with the upper face of the chuck plate.

In an example embodiment, the guide ring and the clamp may be made of aluminum oxide to suppress the heat generated in the heating plate from being lost through the heating plate and the chuck plate.

In an example embodiment, each of the upper surface of the heating plate and a lower surface of the chuck plate may have a flatness of about 10 *µ*m or less to prevent the vacuum force from leaking through a gap between the heating plate and the chuck plate.

In accordance with an exemplary embodiment, a chip separating apparatus includes a chuck structuring including a heating plate having a heating element that generates a heat by an external power source and a first vacuum line extending to an upper surface thereof for providing a vacuum force, and a chuck plate being placed on the heating plate to support a wafer including a plurality of chips, attached to a dicing tape on an upper surface thereof, the chuck plate being configured to transfer heat generated in the heating plate to the wafer so that the chips are separated from the dicing tape, and having a second vacuum line being communicated with the first vacuum line for adsorbing the dicing tape, and a picker for picking up the chips separated from the dicing tape sequentially and transferring the chips for a subsequent process.

In an example embodiment, the picker may include a heater for heating the chips.

In an example embodiment, the heating plate may generate heat to separate the chips from the dicing tape while the picker is in a standby state for separation of the chips.

### [Advantageous Effects]

A chuck plate according to example embodiments of the present invention can be brought into close contact with a heating plate with a vacuum force for adsorbing the wafer. Therefore, the chuck plate can be fixed to the heating plate without an additional fastening member.

A chuck structure according to example embodiments of the present invention can bring the heating plate and the chuck plate into close contact with each other by the vacuum force for adsorbing the wafer. Therefore, an additional fastening member for fastening the heating plate and the chuck plate is not required.

Further, when only the vacuum force is released, the heating plate and the chuck plate can be separated and replaced. Therefore, maintenance for the chuck structure can be performed quickly.

The chuck structure transfers heat generated in the heating plate to the wafer through the chuck plate. The adhesive force of the dicing tape applied to the wafer is decreased by heat, so that the chips can be separated from the dicing tape by the heat transmitted by the chuck plate. Therefore, the chip can be separated without damage.

The chip separating apparatus according to the present invention can separate and transfer chips without damaging the chips using the chuck structure.

### [Description of Drawings]

FIG. 1 is a cross-sectional view illustrating a chuck structure for a semiconductor post processing step according to an example embodiment of the present invention.
FIG. 2 is a plan view of the chuck structure in FIG. 1.
FIG. 3 is a bottom view of the chuck plate in FIG. 1.
FIG. 4 is a bottom view illustrating a chuck plate for a semiconductor post processing step according to an example embodiment of the present invention.
FIG. 5 is an enlarged cross-sectional view of a region "A" in FIG. 1.
FIG. 6 is a cross-sectional view illustrating a chip separating apparatus according to an example embodiment of the present invention.

### [Mode for Invention]

Hereinafter, specific embodiments on an internal member of a plasma processing apparatus and a method of manufacturing the same will be described in detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art. Like reference numerals refer to like elements throughout. In the figures, the dimensions of layers and regions are exaggerated for clarity of illustration.

The terms such as first, second, etc., can be used in describing various elements, but the above elements by the above terms should not be limited. The above terms are one element from the other used only to distinguish. For example, in the present invention without departing from the scope of the first component to the second component may be named similarly, the second component to the first component also can be named.

The terminology used herein is for the purpose of describing particular example embodiments only and is not intended to be limiting of the present inventive concept. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

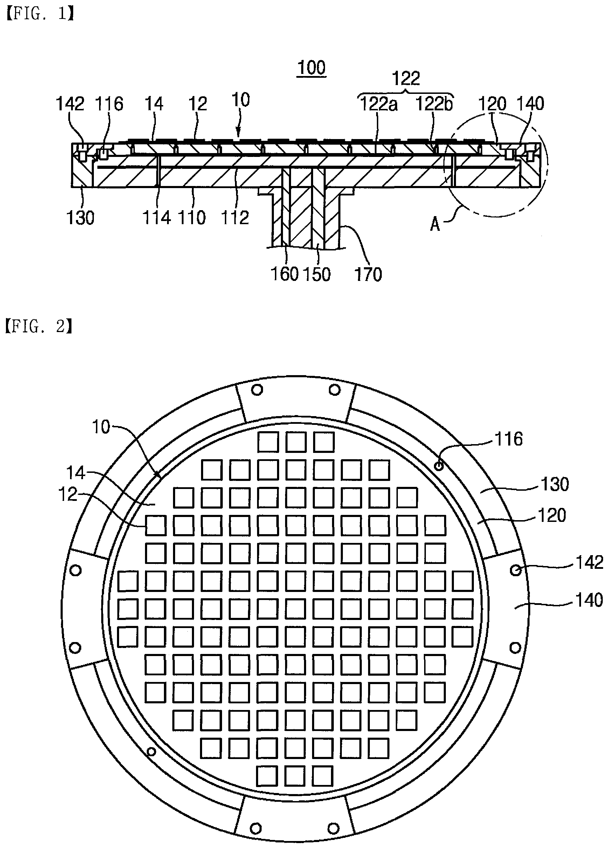

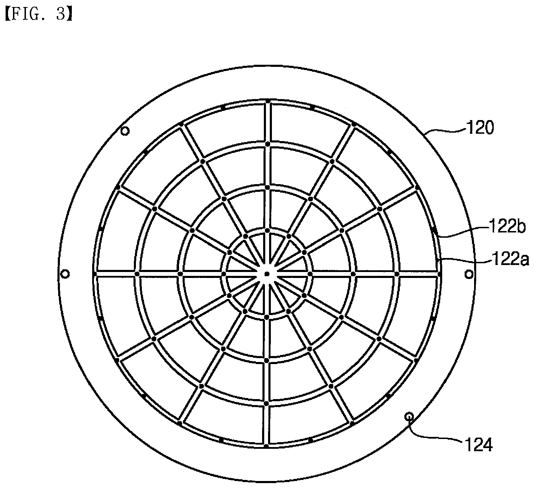

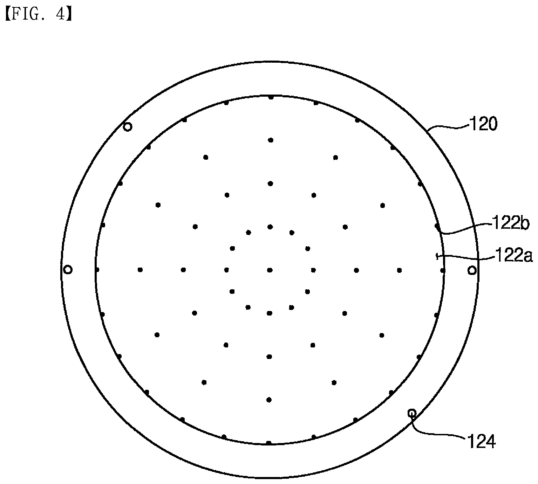

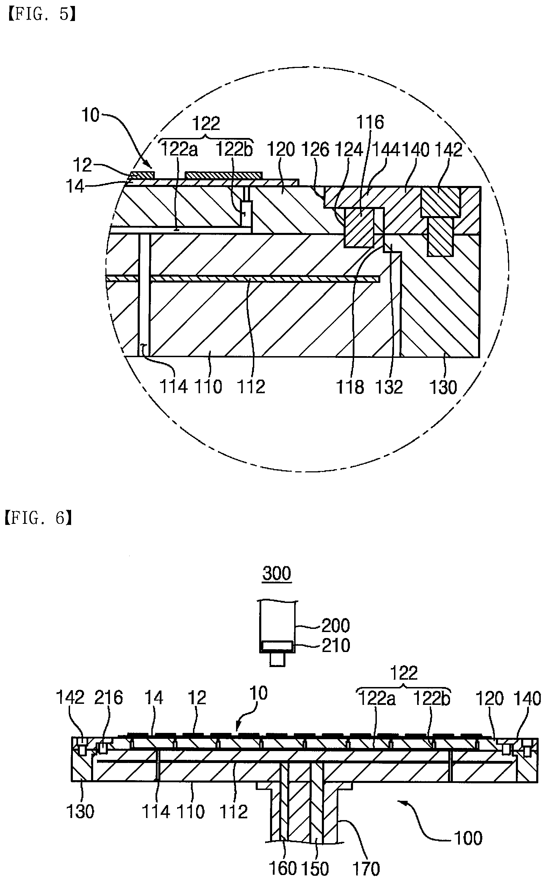

FIG. 1 is a cross-sectional view illustrating a chuck structure for a semiconductor post processing step according to an example embodiment of the present invention, and FIG. 2 is a plan view of the chuck structure in FIG. 1. FIG. 3 is a bottom view of the chuck plate in FIG. 1, and FIG. 4 is a bottom view illustrating a chuck plate for a semiconductor post processing step according to an example embodiment of the present invention. FIG. 5 is an enlarged cross-sectional view of a region "A" in FIG. 1.

Referring to FIGS. 1 to 5, a chuck structure 100 in accordance with an example embodiment supports a wafer 10 including a plurality of chips 12 being diced by a dicing process, and being attached to a dicing tape 14. Since the chuck structure 100 is used in a semiconductor post processing step, the chuck structure 100 may be utilized in an atmospheric pressure state and an oxidizing gas atmosphere, unlike a ceramic heater used in a semiconductor vacuum state and an inert gas atmosphere of a semiconductor preprocessing step.

The chuck structure 100 includes a heating plate 110, a chuck plate 120, a guide ring 130, a clamp 140, a power cable 150, a temperature sensor 160, and a shaft 170.

The heating plate 110 may have a substantially disc shape. The heating plate 110 may incorporate a heating element 112 capable of generating heat by a power source applied from the outside.

The heating element 112 may be provided inside the heating plate 110 of having a predetermined pattern. Examples of the heating element 112 include an electrode layer, a heating coil, and the like.

The heating plate 110 has a first vacuum line 114 extending to an upper surface thereof. The first vacuum line 114 may extend from a lower surface or side of the heating plate 110 to the upper surface. The first vacuum line 114 is connected to a vacuum pump (not shown) and provides a path through which a vacuum force is transferred for adsorbing the wafer 10.

The heating plate 110 may include at least one alignment pin 116 formed on the upper surface thereof. The alignment pin 116 is configured to align the chuck plate 120 with the heating plate 110. Further, a plurality of alignment pins 116 may be provided. The alignment pins 116 may be disposed on an edge portion of the upper surface of the heating plate 110.

Further, the heating plate 110 has a groove 118 formed along an edge portion of the upper surface thereof. The groove 118 may be used to secure the guide ring 130 which surrounds a side wall of the heating plate 110.

The chuck plate 120 may have a substantially disc shape. The chuck plate may be positioned on the heating plate 110. Further, the chuck plate 120 supports the wafer 10 on an upper surface thereof.

The chuck plate 120 has a second vacuum line 122 connected to the first vacuum line 114 for adsorbing the dicing tape 14 on which the wafer 10 is adhered using a vacuum force.

The second vacuum line 122 has a vacuum groove pattern 122a and a plurality of vacuum holes 122b.

The vacuum groove pattern 122a is formed on a lower surface of the chuck plate 120. For example, as shown in FIG. 3, the vacuum groove pattern 122a includes a plurality of first grooves concentrically formed with respect to the center of the lower surface of the chuck plate 120, and a plurality of second grooves radially extending from the center of the lower surface of the chuck plate. The first and the second grooves are communicated with one another. Alternatively, as shown in FIG. 4, the vacuum groove pattern 122a may have a circular groove shape as well. The vacuum groove pattern 112a does not extend in a horizontal direction to a lower edge of the chuck plate 120 to prevent leakage of the vacuum force.

The chuck plate 120 is positioned on the heating plate 110 such that the vacuum groove pattern 122a is confined by the upper surface of the heating plate 110 and the lower surface of the chuck plate 120 to form a vacuum space. Further, the vacuum groove pattern 122a is communicated with the first vacuum line 114.

The vacuum holes 122b extend from the lower surface of the chuck plate 120 where the vacuum groove pattern 122a is formed to the upper surface of the chuck plate 120. The vacuum holes 122b are arranged to be spaced apart from each other. For example, the vacuum holes 122b may be arranged concentrically or radially.

The second vacuum line 122 is communicated with the first vacuum line 114 to be capable of adsorbing the dicing tape 14 of the wafer 10 by the vacuum force provided through the first vacuum line 114.

According to another embodiment of the present invention, although not shown, the second vacuum line 122 is composed of vacuum holes penetrating through the chuck plate 120, and the first vacuum line 114 includes a vacuum groove pattern formed on the upper surface of the heating plate 110 and a plurality of vacuum holes penetrating through the heating plate 110.

The vacuum groove pattern is communicated with the second vacuum line 122. The vacuum groove pattern is confined by the upper surface of the heating plate 110 and the lower surface of the chuck plate 120 to define a vacuum space. The vacuum holes extend through the lower surface of the heating plate 110 and extend to the upper surface where the vacuum groove pattern is formed. The description of the shape of the vacuum groove pattern and the arrangement of the vacuum holes is substantially the same as the description of the shape of the vacuum groove pattern 122a and the arrangement of the vacuum holes 122b described in detail with reference to FIG. 3.

According to another embodiment of the present invention, although not shown in the drawings, the first vacuum line 114 and the second vacuum line 122 may include only a plurality of vacuum holes without a vacuum groove pattern. That is, the first vacuum line 114 includes a plurality of first vacuum holes penetrating from the lower surface to the upper surface of the heating plate 110, and the second vacuum line 122 includes a plurality of second vacuum holes penetrating from the lower surface to the upper surface of the chuck plate 120. Each of the first vacuum holes and the second vacuum holes may be directly communicated with each other without a vacuum groove pattern.

According to another embodiment of the present invention, although not shown in the drawings, both the first vacuum line 114 and the second vacuum line 122 may have a vacuum groove pattern and vacuum holes, respectively. That is, the first vacuum line 114 may have a vacuum groove pattern and a plurality of vacuum holes, and the second vacuum line 122 may have a vacuum groove pattern 122a and a plurality of vacuum holes 122b. The vacuum groove pattern of the first vacuum line 114 and the vacuum groove pattern 122a of the second vacuum line 122 may be communicated with each other.

A gap may exist between the heating plate 110 and the chuck plate 120 in case that the upper surface of the heating plate 110 and the lower surface of the chuck plate 120, each has a flatness over about 10 *µ*m. Accordingly, the vacuum force can leak through the fine gap between the heating plate 110 and the chuck plate 120.

Each of the upper surface of the heating plate 110 and the lower surface of the chuck plate 120 may has a flatness of about 10 *µ*m or less, preferably 7 10 *µ*m or less. In this case, the heating plate 110 and the chuck plate 120 can be in tightly contact with each other, and the vacuum force can be prevented from leaking through the gap between the heating plate 110 and the chuck plate 120.

The heating plate 110 and the chuck plate 120 can be kept in close contact by the vacuum force provided through the first vacuum line 114 and the second vacuum line 122. Therefore, a connecting member may not be required for fastening the heating plate 110 to the chuck plate 120.

Further, only when the vacuum force is released, the heating plate 110 and the chuck plate 120 can be separated from each other and one of the heating plate 110 and the chuck plate 120 can be replaced. Therefore, the maintenance of the chuck structure 100 can be performed quickly and easily.

The chuck plate 120 may transfers a heat generated in the heating plate 110 into the wafer 10. Thus, an adhesive force of the dicing tape 14 on which the chips are attached is weakened owing to the heat so that the chip 12 can be easily separated from the dicing tape 14 by the heat transmitted by the chuck plate 120. Therefore, the chip 12 can be just separated from the dicing tape without mechanically damaging the chip 12.

The heating plate 110 and the chuck plate 120 may be made of aluminum nitride (AlN), respectively. Since the aluminum nitride has a relatively high thermal conductivity, the heat generated from the heating element 112 can be uniformly transferred through the heating plate 110 and the chuck plate 120. In addition, the temperature distribution of the chuck plate 120 can be kept uniform, and the wafer 10 and the dicing tape 14 can be uniformly heated.

The chuck plate 120 has a receiving groove 124 for receiving the alignment pin 116. The receiving groove 124 may be formed at a position corresponding to the alignment pin 116 of the heating plate 110. For example, the receiving groove 124 may also be disposed at an edge portion of the chuck plate 120.

The alignment pins 116 of the heating plate 110 can be inserted into the receiving grooves 124 of the chuck plate 120 when the chuck plate 120 is placed on the upper surface of the heating plate 110. Accordingly, the heating plate 110 and the chuck plate 120 can be accurately aligned to each other.

Although the aligning pin 116 is provided in the heating plate 110 and the receiving groove 124 is formed in the chuck plate 120, the receiving groove 124 may be formed in the heating plate 110, alignment pins may be provided with in the chuck plate120 in accordance with another example embodiment.

The chuck plate 120 also has a groove 126 formed along an upper edge portion thereof. The groove 126 may be used to provide a space for positioning a clamp 140.

The guide ring 130 is fixed on the groove 118 formed along the upper edge portion of the heating plate 110 to guide a periphery of the heating plate 110.

Specifically, the guide ring 130 has a locking projection 132, and the guide ring 130 is mounted on the heating plate 110 as the locking projection 132 hangs on the groove 118.

Meanwhile, the upper surface of the guide ring 130 may be coplanar with the upper surface of the heating plate 110. Thus, the chuck plate 120 can be easily placed on the upper surface of the heating plate 110 in a state that the guide ring 130 is mounted on the heating plate 110.

In case that the upper surface of the guide ring 130 is positioned higher than that of the heating plate 110, the guide ring 130 can be used as an alignment reference, when the chuck plate 120 is placed on the upper surface of the heating plate 110.

The clamp 140 is fixed to the guide ring 130 while covering an edge portion of the upper surface of the chuck plate 120. The clamp 140 can be fixed to the guide ring 130 by a fastening screw 142.

In one example, a plurality of clamps 140 may be provided to partially cover the edge portion of the chuck plate 120. In another example, the clamp 140 may have a generally ring shape and may entirely cover the edge portion of the chuck plate 120.

The clamp 140 may be fixed to the guide ring 130 while covering the edge portion of the upper surface of the chuck plate 120 so that the clamp 140 can press the chuck plate 120 downward. Therefore, the clamp 140 can bring the chuck plate 120 into closer contact with the heating plate 110. As a result, it is possible to further prevent the vacuum force from leaking through the gap between the heating plate 110 and the chuck plate 120.

The clamp 140 may include a locking projection 144. The locking projection 144 can be placed in the groove 126 which is formed at the top edge portion of the chuck plate 120. Therefore, the upper surface of the clamp 140 may be coplanar with the upper surface of the chuck plate 120. Therefore, the wafer 10 can be stably transported to the upper surface of the chuck plate 120 without disturbance of the clamp 140.

The guide ring 130 and the clamp 140 may be made of aluminum oxide (Al2O3). Since the aluminum oxide has heat insulating properties, the guide ring 130 and the clamp 140 can prevent heat form dissipating through a side surface of the heating plate 110 and the chuck plate 120.

The power cable 150 extends into inside of the heating plate 110 and is connected to the heating element 112. The power cable 150 may provide the heating element 112 with power for generating heat.

The temperature sensor 160 (see FIG. 1) extends from outside of the heating plate 110 to inside thereof. The temperature sensor 160 measures a temperature of the heating element 112 for controlling the temperature of the heating element 112.

An example of the temperature sensor 160 is a thermocouple.

The shaft 170 is provided on the lower surface of the heating plate 110 to support the heating plate 110. For example, the shaft 170 may be bolted to the heating plate 110.

The power cable 150 and the temperature sensor 160 can be mounted on the heating plate 110 through the shaft 170 such that the shaft 170 may serve to secure the power cable 150 and the temperature sensor 160 together.

The shaft 170 may be made of a material different from that of the heating plate 110. Therefore, it may be possible to prevent heat generated in the heating plate 110 from being lost through the shaft 170.

In particular, the shaft 170 may be made of aluminum oxide (Al2O3) material having heat insulating properties. Therefore, it is possible to further suppress the heat generated in the heating plate 110 from being lost through the shaft 170.

The chuck structure 100 can make the heating plate 110 and the chuck plate 120 into closer contact with each other by a vacuum force for adsorbing the wafer 10. Therefore, an additional fastening member for fastening the heating plate 110 and the chuck plate 120 is unnecessary.

Further, when only the vacuum force is released, the heating plate 110 and the chuck plate 120 can be easily separated and replaced. Therefore, the maintenance of the chuck structure 100 can be performed quickly.

The chuck structure 110 transfers heat generated in the heating plate 110 to the wafer 10 through the chuck plate 120. The adhesive force of the dicing tape 14 is weakened due to the heat so that the chip 12 can be easily separated from the dicing tape 14 by the heat transmitted by the chuck plate 120. Therefore, the chip 12 can be thermally separated from the dicing tape 14 without mechanically damaging the chip 12.

FIG. 6 is a cross-sectional view illustrating a chip separating apparatus according to an example embodiment of the present invention.

Referring to FIG. 6, a chip separating apparatus 300 according to an example embodiment includes a chuck structure 100 and a picker 200.

The chuck structure 100 includes a heating plate 110, a chuck plate 120, a guide ring 130, a clamp 140, a power cable 150 and a temperature sensor 160. A detailed description thereof will be omitted because it is substantially the same as the description with reference to Figs. 1 to 5.

The chuck structure 100 generates a heat by the heating plate 110 in a state in which the picker 200 is waiting before picking up the chips 12. The heat is transferred to a wafer 10 through the chuck plate 120 to separate the chips 12 from a dicing tape 14. It is not necessary to spend the time for separating the chips 12 from the tape 14 so that the picker 200 can pick up the chips 12 without delay.

The picker 200 is provided so as to be movable in a horizontal direction and a vertical direction above the chuck structure 100. The picker 200 sequentially picks up the chips 12 separated from the dicing tape 14 and feeds the chip for a subsequent process. The picker 200 can adsorb the chips 12 by using a vacuum force.

For example, the picker 200 may transfer the chips 12 to a buffer stage, or may directly bond the chips 12 to the substrate.

When the picker 200 bonds the chips 12, the picker 200 may include a heater 210 therein.

The heater 210 heats the chip 12 to allow the chip 12 to be stably bonded to the substrate.

The chip separating apparatus 300 separates the chip 12 from the dicing tape 14 using the heat generated in the chuck structure 110 and transfers the separated chip 12 using the picker 200. Therefore, the chip separating apparatus 300 can be separated and transported without mechanically damaging the chip 12.

### [Industrial Applicability]

As described above, the chucking plate for a semiconductor post processing step, the chucking structure having the chuck plate, and the chip separating apparatus having the chuck structure according to the present invention can make the heating plate and the chuck plate into close contact with each other using the vacuum force for adsorbing the wafer. The heating plate and the chuck plate can be easily separated from each other by releasing only the vacuum force, so that maintenance or replacement of the chuck structure can be performed quickly.

The foregoing is illustrative of the present teachings and is not to be construed as limiting thereof. Although a few exemplary embodiments have been described, those skilled in the art will readily appreciate from the foregoing that many modifications are possible in the exemplary embodiments without materially departing from the novel teachings and advantages of the present disclosure of invention. Accordingly, all such modifications are intended to be included within the scope of the present teachings. In the claims, means-plus-function clauses are intended to cover the structures described herein as performing the recited function and not only structural equivalents but also functionally equivalent structures.

## Claims

1. A chuck plate for a semiconductor post processing step, comprising:
a plurality of vacuum holes penetrating therethrough to adsorb a dicing tape using a vacuum force,
wherein the chuck plate to be placed on a heating plate, supports a wafer including a plurality of chips of being attached to the dicing tape, and heat generated in the heating plate transfers to the wafer for separating the chips from the dicing tape.

2. The chuck plate of claim 1, further comprising a vacuum groove pattern being communicated with the vacuum holes formed on a lower surface of the chuck plate.

3. The chuck plate of claim 1, wherein the chuck plate has a lower surface having a flatness of about 10 *µ*m or less.

4. A chuck structure comprising:
a heating plate having a heating element that generates a heat by an external power source, and a first vacuum line extending to an upper surface thereof for providing a vacuum force; and
a chuck plate placed on the heating plate to support a wafer including a plurality of chips of being attached to a dicing tape on an upper surface thereof, the chuck plate being configured to transfer heat generated in the heating plate to the wafer so that the chips are separated from the dicing tape, and having a second vacuum line being communicated with the first vacuum line for adsorbing the dicing tape.

5. The chuck structure of claim 4, wherein the second vacuum line comprises:
a vacuum groove pattern communicated to the first vacuum line, the vacuum groove pattern being formed on a lower surface of the chuck plate to define a vacuum space together with the lower surface of the chuck plate and the upper surface of the heating plate; and
a plurality of vacuum holes extending through the chuck plate and from the lower surface to the upper surface of the chuck plate.

6. The chuck structure of claim 4, wherein the first vacuum line comprises:
a vacuum groove pattern communicated to the second vacuum line, the vacuum groove pattern being formed on the upper surface of the heating plate to define a vacuum space together with an lower surface of the chuck plate and the upper surface of the heating plate; and
a plurality of vacuum holes extending through the heating plate and from the lower surface to the upper surface of the heating plate.

7. The chuck structure of claim 4, further comprising:
an alignment pin disposed on one of the upper surface of the heating plate and a lower surface of the chuck plate; and
a receiving groove formed on the other of the upper surface of the heating plate and the lower surface of the chuck plate for receiving the alignment pin.

8. The chuck structure of claim 4, wherein the heating plate and the chuck plate are made of aluminum nitride (AlN) to uniformly transmit heat generated from the heating plate such that the chuck plate has a uniform temperature distribution internally.

9. The chuck structure of claim 4, further comprising:
a guide ring which hangs on a groove formed along an edge portion of the upper surface of the heating plate to guide a periphery of the heating plate; and
a clamp being fixed to the guide ring while covering an edge portion of the upper surface of the chuck plate to make the chuck plate in contact with the heating plate for fixing the chuck plate to the heating plate.

10. The chuck structure of claim 9, wherein the clamp hangs on a groove formed along a peripheral portion of the chuck plate such that an upper surface of the clamp is coplanar with the upper face of the chuck plate.

11. The chuck structure of claim 9, wherein the guide ring and the clamp is made of aluminum oxide to suppress the heat generated in the heating plate from being lost through the heating plate and the chuck plate.

12. The chuck structure of claim 4, wherein each of the upper surface of the heating plate and a lower surface of the chuck plate has a flatness of about 10 *µ*m or less to prevent the vacuum force from leaking through a gap between the heating plate and the chuck plate.

13. A chip separating apparatus comprising:
a chuck structuring including a heating plate having a heating element that generates a heat by an external power source and a first vacuum line extending to an upper surface thereof for providing a vacuum force, and a chuck plate being placed on the heating plate to support a wafer including a plurality of chips, attached to a dicing tape on an upper surface thereof, the chuck plate being configured to transfer heat generated in the heating plate to the wafer so that the chips are separated from the dicing tape, and having a second vacuum line being communicated with the first vacuum line for adsorbing the dicing tape; and
a picker for picking up the chips separated from the dicing tape sequentially and transferring the chips for a subsequent process.

14. The chip separating apparatus of claim 13, wherein the picker includes a heater for heating the chips.

15. The chip separating apparatus of claim 13, wherein the heating plate generates heat to separate the chips from the dicing tape while the picker is in a standby state for separation of the chips.
